# EUROPEAN PATENT APPLICATION

(11) **EP 4 718 701 A1**
(43) Date of publication of application: **01.04.2026**
(21) Application number: 25197086.9
(22) Date of filing: 20.08.2025
(51) Int. Cl.: H02M 3/07, H02M 1/08, H02M 1/00

(54) **SWITCHED CAPACITOR CONVERTER**

(30) Priority: 27.09.2024 US 202418898936
(71) Applicant: INTEL Corporation, Santa Clara, CA 95054 (US)
(72) Inventor: ZHANG, Huanhuan, 01721 Ashland (US); RAGHAVAN, Arvind, 02420 Lexington (US); CHEN, Keng, 01720 Acton (US); SALUS, Tamir, 3093260 Zichron Yaakov (IL); MASILAMANI, Sivaraman, 30066 Marietta (US)
(74) Representative: HGF

(57) **Abstract**

An apparatus includes a clock generation circuit coupled to a power train (PTR) circuit. The clock generation circuit includes an adaptive delay circuit to generate a first clock signal and a first clock delay signal based on a regulation clock signal. The clock generation circuit includes a fixed time delay circuit to generate a second clock signal and a second clock delay signal based on the regulation clock signal. The PTR circuit is to receive the first clock signal, the second clock signal, the first clock delay signal, and the second clock delay signal. The PTR circuit generates a voltage output signal based on the first clock signal, the second clock signal, the first clock delay signal, and the second clock delay signal.

## Description

### BACKGROUND

For a multi-stage switching capacitor converter in a large current domain (e.g., hundreds of Amps), it is challenging to propagate a high-speed clock (e.g., 300 MHz) in a significant physical layout domain and to generate the proper deadtime (also referred to as deadtime clock or deadtime delay) for each stage that guarantees a sufficient current density considering the large voltage, process, and temperature (PVT) variations.

### BRIEF DESCRIPTION OF THE DRAWINGS

In the drawings, like numerals may describe the same or similar components or features in different views. Like numerals having different letter suffixes may represent different instances of similar components. Some embodiments are illustrated by way of example, and not limitation, in the figures of the accompanying drawings listed below.
FIG. 1 is a block diagram of a system for generating a deadtime clock for a multi-stage switched capacitor converter, in accordance with some embodiments.
FIG. 2 illustrates an adaptive delay circuit for adaptive deadtime clock generation, in accordance with some embodiments.
FIG. 3 is a block diagram of a fixed time delay circuit for deadtime clock generation, in accordance with some embodiments.
FIG. 4 is a block diagram of a self-detection circuit to generate a self-detection deadtime clock signal, in accordance with some embodiments.
FIG. 5 is a block diagram of a self-detection circuit using a skewed inverter to generate a self-detection deadtime clock signal, in accordance with some embodiments.
FIG. 6 is a block diagram of a self-detection circuit using a Vgs shift to generate a self-detection deadtime clock signal, in accordance with some embodiments.
FIG. 7 illustrates a graph of Vgate and clk_dly_lc (Vdet) for varying supplies, in accordance with some embodiments.
FIG. 8 illustrates a graph of Vgate and clk_dly_lc (Vdet) under different skews (e.g., tttt, rsssas, rfffaf, rxsf, and rxfs skews), in accordance with some embodiments.
FIG. 9 is a block diagram of a self-detection circuit using an adjustment loop to generate a self-detection deadtime clock signal, in accordance with some embodiments.
FIG. 10 is a flow diagram of an example method for manufacturing a converter circuit, in accordance with some embodiments.
FIG. 11 illustrates a block diagram of an example machine upon which any one or more of the operations/techniques (e.g., methodologies) discussed herein may perform.

### DETAILED DESCRIPTION

The following detailed description refers to the accompanying drawings. The same reference numbers may be used in different drawings to identify the same or similar elements. In the following description, for purposes of explanation and not limitation, specific details are set forth, such as particular structures, architectures, interfaces, techniques, etc., to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

The following description and the drawings sufficiently illustrate specific embodiments to enable those skilled in the art to practice them. Other embodiments may incorporate structural, logical, electrical, process, and other changes. Portions and features of some embodiments may be included in or substituted for those of other embodiments. Embodiments outlined in the claims encompass all available equivalents of those claims.

As used herein, the term "chip" (or die) refers to a piece of a material, such as a semiconductor material, that includes a circuit, such as an integrated circuit or a part of an integrated circuit. The term "memory IP" indicates memory intellectual property. The terms "memory IP," "memory device," "memory chip," and "memory" are interchangeable.

The term "a processor" configured to carry out specific operations includes both a single processor configured to carry out all of the operations (e.g., operations or methods disclosed herein) as well as multiple processors individually configured to carry out some or all of the operations (which may overlap) such that the combination of processors carry out all of the operations.

As used herein, the term "IO" indicates input/output. As used herein, the term "R-C" indicates resistance and capacitance. As used herein, the term "Rx" indicates receiver (or receive). As used herein, the term "Tx" indicates transmitter (or transmit). As used herein, the term "TRX" indicates transceiver. As used herein, the term "UCIe" indicates Universal Chiplet Interconnect Express. As used herein, the term "Vref" indicates reference voltage. As used herein, the term "Vin" indicates input voltage. As used herein, the terms "serially coupled," "serially connected," and "connected in series" are synonymous to each other and indicate a serial connection between two or more components/circuits where the serial connection can be based on a direct or indirect electrical connection between the two or more components/circuits. As used herein, the terms "parallel coupled," "parallel connected," and "connected in parallel" are synonymous to each other and indicate a parallel connection between two or more components/circuits where the parallel connection can be based on a direct or indirect electrical connection between the two or more components/circuits.

The disclosed techniques can be used to generate a high-quality clock and deadtimes for each power train stage that is adaptive to PVT variations. Thus, a high current density and high efficiencies at moderate and high current loads are achieved based on the disclosed techniques and circuit configurations.

In some aspects, a delay chain-based delay is selected and propagated to all the PTR (power train) stages. The variation across PVT of this inverter-based delay where the supply is 1V with 10% variation can be associated with a delay that varies from 240 ps to 604 ps (e.g., 2.5X delay time span). In some aspects, the gate voltage ramps in an actual switch under PVT where voltage ranges from 0.6V to 1.2V. This ramp time, which is the demanded deadtime, ranges from ~60ps up to 1ns. Since the delay chain and the power switches are uncorrelated, to guarantee sufficient deadtime, the selected delay can be greater than 1 ns, a much over-designed number for fast and high supply cases. The maximum frequency of the targeted application can be approximately 300 MHz, making the maximum current density 30% less for a fast and high voltage scenario, as well as the degraded efficiencies at moderate and high current loads.

The disclosed techniques are associated with the following advantages:
(a) Achieve robust deadtime control in a complex multi-stage heavy domain switched converter, which results in an efficient high-current density converter design; and
(b) Being an adaptive design for current-hungry second and third PTR stages, it is robust with PVT, making it suitable for advanced process nodes.

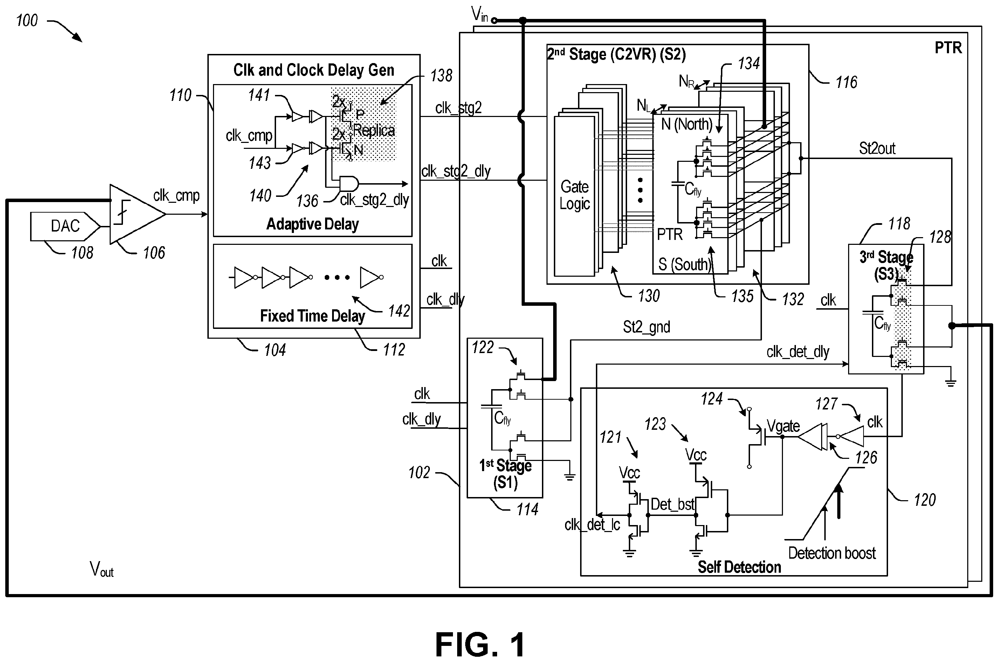

FIG. 1 is a block diagram of system 100 for generating a deadtime clock for a multi-stage switched capacitor converter, in accordance with some embodiments. Referring to FIG. 1, system 100 includes a clock generation circuit 104 (also referred to as a clock and clock delay generation circuit), a comparator 106, and a PTR circuit 102 (which can be a switching converter with three-stage PTRs).

The clock generation circuit 104 includes an adaptive delay circuit 110 configured to generate clock signal clk_stg2 and clock delay signal clk_stg2_dly based on a regulation clock signal clk_cmp generated by comparator 106.

The clock generation circuit 104 also includes a fixed time delay circuit 112 configured to generate a clock signal clk and a clock delay signal clk_dly using a plurality of inverters 142 and the regulation clock signal clk_cmp.

The PTR circuit 102 includes a first PTR stage circuit 114, a second PTR stage circuit 116 (which can be referred to as a continuous capacitive voltage regulator or C2VR), and a third PTR stage circuit 118.

The first PTR stage circuit 114 can include a switched capacitor circuit 122 configured to generate a ground signal St2_gnd based on the voltage input signal Vin and clock signals clk and clk_dly.

The second PTR stage circuit 116 includes gate logic 130 and C2VR 132. The C2VR 132 can include a plurality of PMOS transistors 134 and a plurality of NMOS transistors 135 coupled via a fly capacitor Cfly (as illustrated in FIG. 1). The gate logic 130 is configured to generate switch control signals for the C2VR 132 based on the clock signals clk_stg2 and clk_stg2_dly generated by the adaptive delay circuit 110. The C2VR 132 generates an output signal St2out (e.g., an output voltage signal) based on the switch control signals.

In some aspects, the adaptive delay circuit 110 includes a buffer circuit 141, an inverter circuit 143, driver circuits 140, an AND gate 136, and replica transistors 138. In some aspects, transistors 138 include replica transistors (e.g., a PMOS replica transistor corresponding to the PMOS transistors 134 and an NMOS replica transistor corresponding to the plurality of NMOS transistors 135). In some aspects, replica transistors 138 are 2 times the transistor value of the corresponding PMOS transistors 134 and NMOS transistors 135.

The third PTR stage circuit 118 includes a switched capacitor circuit 128 configured to generate an output voltage signal Vout based on the output signal St2out and clock signals clk and clk_det_dly (e.g., a deadtime delay clock) generated by the self-detection circuit 120.

The self-detection circuit 120 can include an inverter circuit 127, driver circuits 126, PMOS transistor 124, skewed inverter circuit 123, and skewed buffer circuit 121. In some aspects, PMOS transistor 124 can be a switch/transistor used by the switched capacitor circuit 128. In some aspects, the self-detection circuit 120 can be configured as part of the third PTR stage circuit 118.

The output voltage signal Vout generated by the third PTR stage circuit 118 is compared by comparator 106 with a reference clock signal generated by a digital-to-analog converter (DAC) 108 to generate the regulation clock signal clk_cmp.

With clk_cmp from the feedback loop, clk_stg2_dly is generated from the replica-based adaptive delay circuit 110 and dedicated to the second PTR stage circuit 116. Clk_dly is generated via a delay chain-based configurable fixed time delay circuit 112 and consumed by the first PTR stage circuit 114. The deadtime of the third PTR stage is achievable by a self-detection method where a detection circuit with a boosted detection point detects the real switch gate voltage.

Referring again to FIG. 1, in the three-stage-PTR switching converter (PTR circuit 102), the first PTR stage circuit 114 generates a virtual ground for the second PTR stage circuit 116, followed by the third PTR stage circuit 118 as a current multiplier. The second PTR stage circuit uses a C2VR architecture, while the first and third PTR stages use fixed ratio switched converters. From clk_cmp of the feedback loop, clk_stg2_dly is generated from a replica-based adaptive delay generation block and is dedicated to C2VR only. Clk_dly is generated via a delay chain-based, configurable fixed-time delay block and consumed by the first PTR stage circuit. The first PTR stage circuit only supplies the C2VR ground current, which is a small current compared with those of the second and third PTR stages. Thus, the first PTR stage does not have a tight constraint on deadtime settings. With a generous deadtime setting and an overdesign for the first PTR stage circuit switch driver, the fixed-time delay works for all PVT conditions.

The third PTR stage circuit 118 has a different requirement as it needs to support the maximum current load. The physical design is constrained for area optimization. To have a better adaptive design over PVT, the third PTR stage circuit deadtime is achievable by a self-detection method. As a two-phase converter system, the switch gate voltage is detected by a detection circuit where the detection point is boosted up and then fed back to the third PTR stage circuit.

In an example application, Vin can vary from 1.5V-3V, and Vout can vary from 0.5V to 1.2V. The load current can be up to 350mA per unit PTR (power train with three stages shown in FIG. 1). An essential switch characterization can be done under a supply range of 0.6 to 1.2V, temperature span of -40 to 125C, and all corners. The ramp-up ranges from 60ps to 1ns can indicate an adaptive deadtime is more realistic for good qualities.

For the second PTR stage circuit where a C2VR architecture is used, there can be approximately 12 power switches, making it area-constrained. A fixed deadtime method can use an overdesign of drivers, which means more area and more power loss from driver leakages, as well as a sufficient deadtime setting under all PVT. All the above make the fixed deadtime method costly for C2VR. With approximately 15 phases, the real switch self-detection method may not be applicable. A replica-based adaptive deadtime generation circuit can be employed to provide clock and clock delay for the C2VR stages.

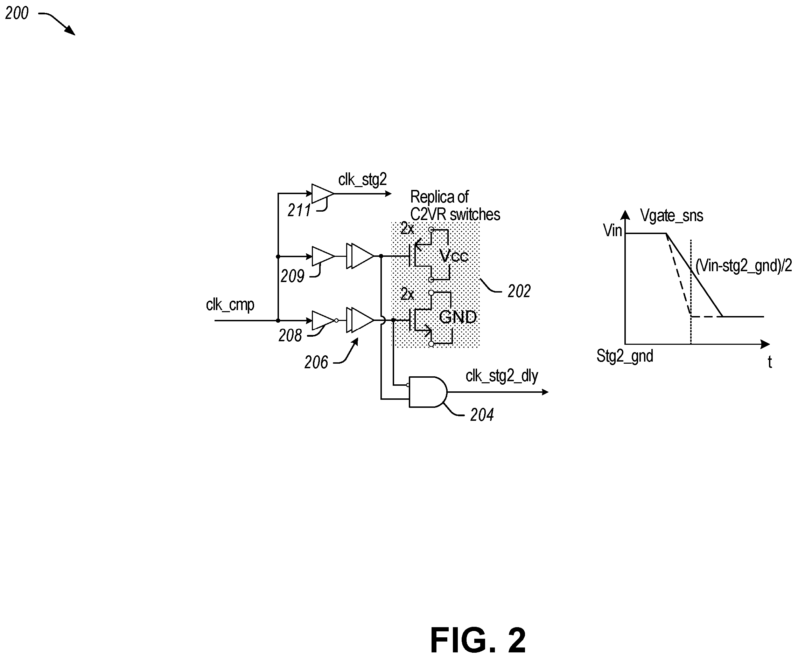

FIG. 2 illustrates an adaptive delay circuit 200 for adaptive deadtime clock generation, in accordance with some embodiments. Referring to FIG. 2, the adaptive delay circuit 200 can be the same as the adaptive delay circuit 110 and can include a buffer circuit 211, a buffer circuit 209, an inverter circuit 208, driver circuits 206, an AND gate 204, and replica transistors 202 (e.g., a PMOS replica transistor corresponding to the PMOS transistors 134 and an NMOS replica transistor corresponding to the plurality of NMOS transistors 135).

In the adaptive delay circuit 200, a P switch replica of the main C2VR P-type switches and an N switch replica of the main C2VR N-type switches are used as replica transistors 202 for real detection. To mitigate the 0 crossing or supply crossing point to mid-rail detection, the driver-to-switch gate ratio is 2x of what is in the C2VR main switch. The real detection is achieved by the AND gate 204, and the generated deadtime clk_stg2_dly is adaptive to supply voltage (the same supply as in the C2VR: Vin and stg2_gnd), temperatures and skews.

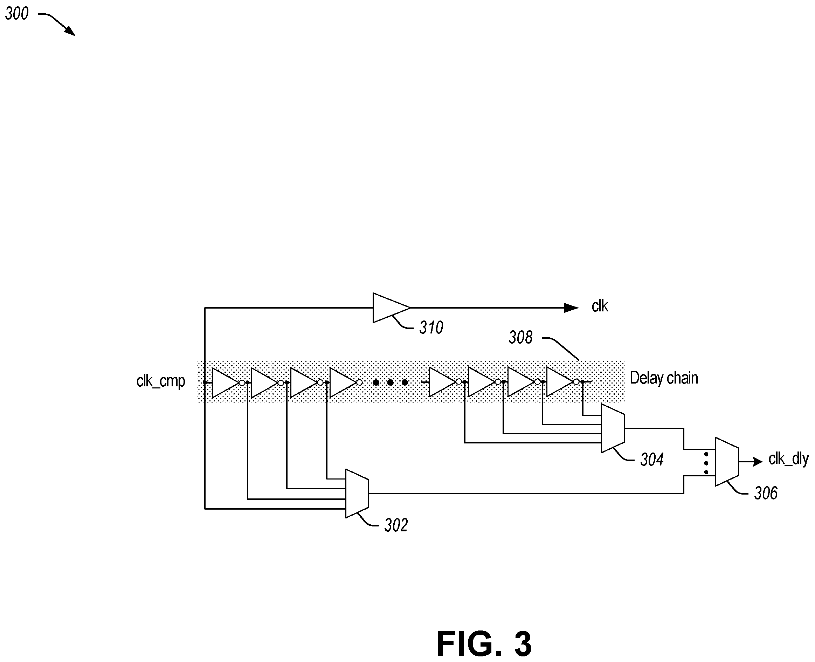

The first PTR stage circuit is the least power-hungry stage since it only supplies current for the C2VR ground. Besides, it is a 2-1 ratio switched capacitor architecture with much fewer switches than in the C2VR. As a result, the first PTR stage circuit is more flexible in areas and charge transfer speed, resulting in more tolerance in the overdesigned driver-to-switch gate ratio and a deadtime with margins. In this regard, a fixed deadtime method is chosen for the first PTR stage circuit with its diagram shown in FIG. 3.

FIG. 3 is a block diagram of a fixed time delay circuit 300 for deadtime clock generation, in accordance with some embodiments. Referring to FIG. 3, the fixed time delay circuit 300 can be the same as the fixed time delay circuit 112. In some aspects, the fixed time delay circuit 300 includes a buffer 310 and a delay chain 308 (e.g., including a series of connected inverters) coupled to multiplexers 302, 304, and 306. As illustrated in FIG. 3, deadtime (e.g., clk_dly) is constructed with a delay chain and configurations.

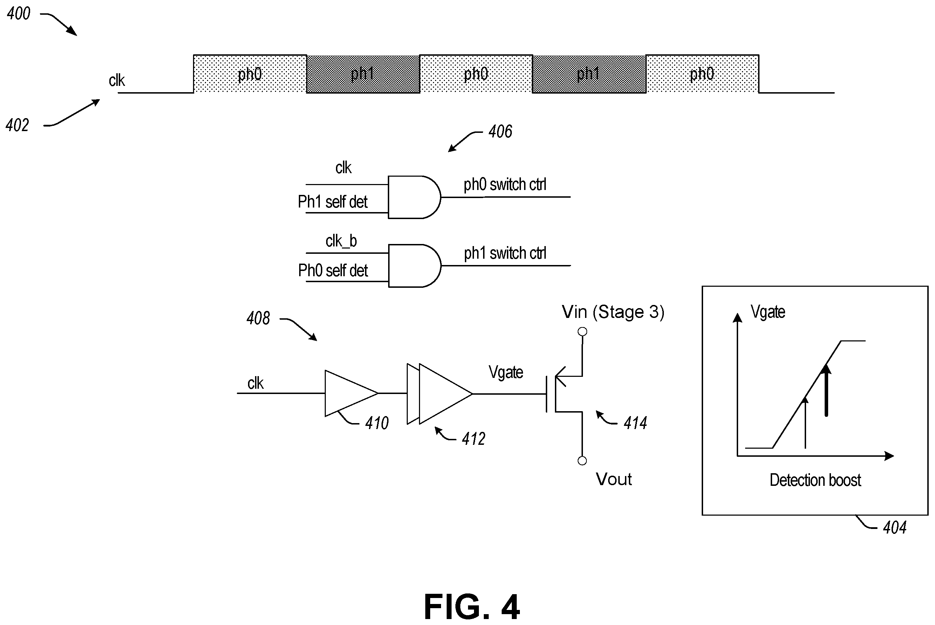

FIG. 4 is a block diagram 400 of a self-detection circuit 408 to generate a self-detection deadtime clock signal, in accordance with some embodiments. FIG. 4 also illustrates a Vgate graph 404 and a phase timing diagram 402 based on phase switch control signals generated by AND gates 406.

Referring to FIG. 4, self-detection circuit 408 can be similar to self-detection circuit 120 and can include buffer circuit 410, driver circuit 412, and a PMOS transistor 414.

Similar to the first PTR stage circuit, the third PTR stage circuit 118 is a fixed ratio switched capacitor structure. It needs to support the maximum current loading, so its area is larger than the area of the first PTR stage circuit but smaller than the area of the second PTR stage circuit 116, as there are two phases and fewer switches. An area-efficient design for the third PTR stage circuit is also needed, which is achieved by a self-detection method (e.g., using at least one of the the self-detection circuits disclosed herein). As a fixed ratio switched capacitor, the third PTR stage circuit operates as a two-phase system. FIG. 4 shows a PMOS power switch, with phase 0 switch controls generated by clk and a delay from phase 1 gate detection. Similarly, phase 1 switch controls are generated by clk_b and a delay from phase 0 gate detection.

In FIG. 4, Vgate is the actual gate voltages of the third PTR stage circuit converters. The self-detection's detect point is lifted from mid-rail to somewhere closer to the supply crossover voltage, leaving only a small percent of the switching time undetected, which will be covered by propagation delay.

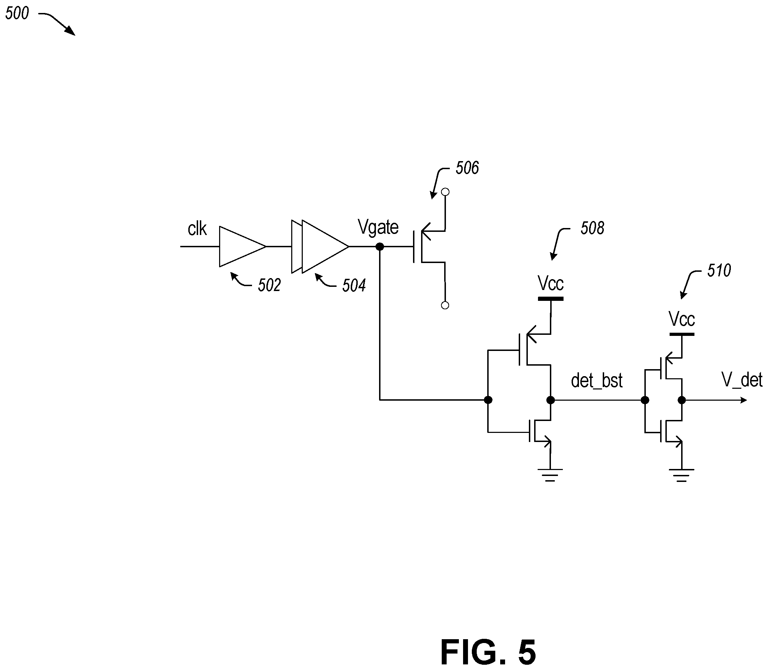

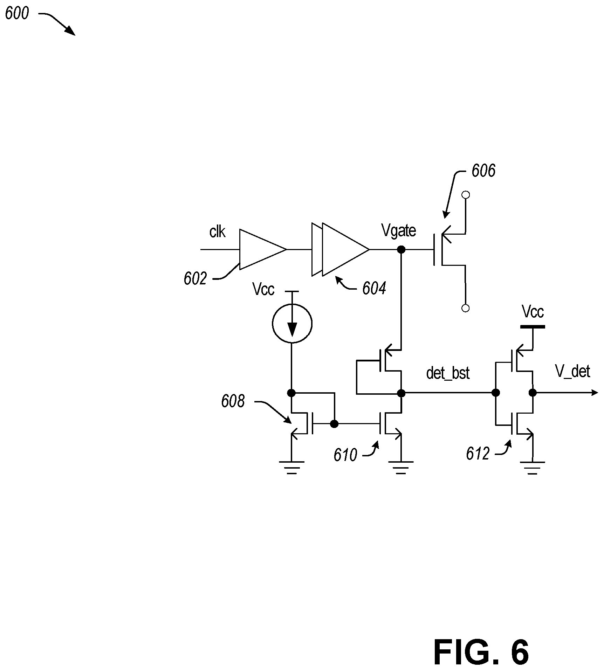

The implementations of boosting the detection point are shown in FIG. 5 and FIG. 6.

FIG. 5 is a block diagram of a self-detection circuit 500 using a skewed inverter to generate a self-detection deadtime clock signal, in accordance with some embodiments. Referring to FIG. 5, self-detection circuit 500 includes a buffer circuit 502, driver circuits 504, PMOS transistor 506, a skewed inverter circuit 508, and a skewed buffer circuit 510.

FIG. 6 is a block diagram of a self-detection circuit 600 using a Vgs shift to generate a self-detection deadtime clock signal, in accordance with some embodiments. Referring to FIG. 6, self-detection circuit 600 includes buffer circuit 602, driver circuits 604, PMOS transistor 606, NMOS transistor 608, a skewed inverter circuit 610, and a skewed buffer circuit 612.

In some aspects, the detection point shift is achieved by a skewed inverter where the PMOS drive strength is higher than NMOS in FIG. 5, whereas the midpoint shift is achieved by lowering gate voltage by one Vgs before logic gate detection in FIG. 6.

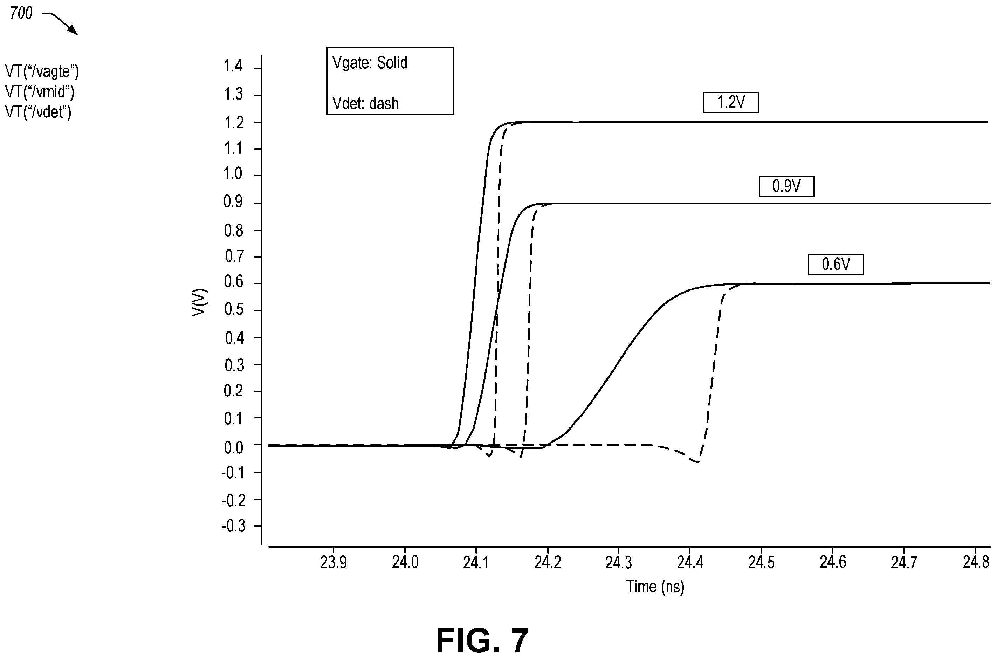

FIG. 7 illustrates graph 700 of Vgate and clk_dly_lc (Vdet) for varying supplies, in accordance with some embodiments.

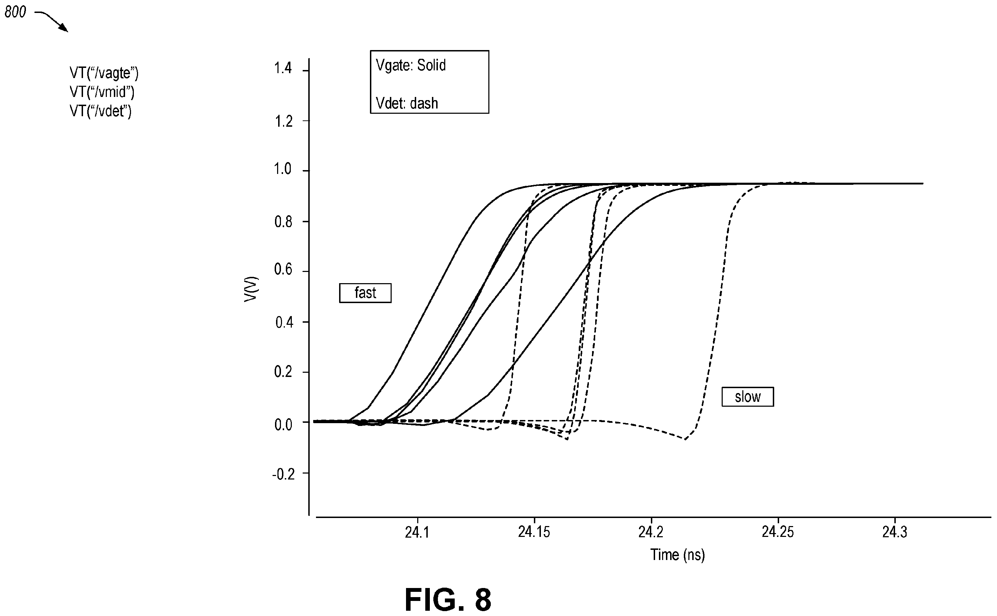

FIG. 8 illustrates graph 800 of Vgate and clk_dly_lc (Vdet) under different skews (e.g., tttt, rsssas, rfffaf, rxsf, and rxfs skews), in accordance with some embodiments.

FIG. 7 shows the simulation result of Vgate and Vdet under a supply voltage of 0.6V, 0.9V, and 1.2V in typical 80C. FIG. 8 is simulated under tttt, rsssas, rfffaf, rxsf, rsfs with 0.9V and 80C. In both cases, Vdet is tripped after Vgate crosses over the supply voltage level.

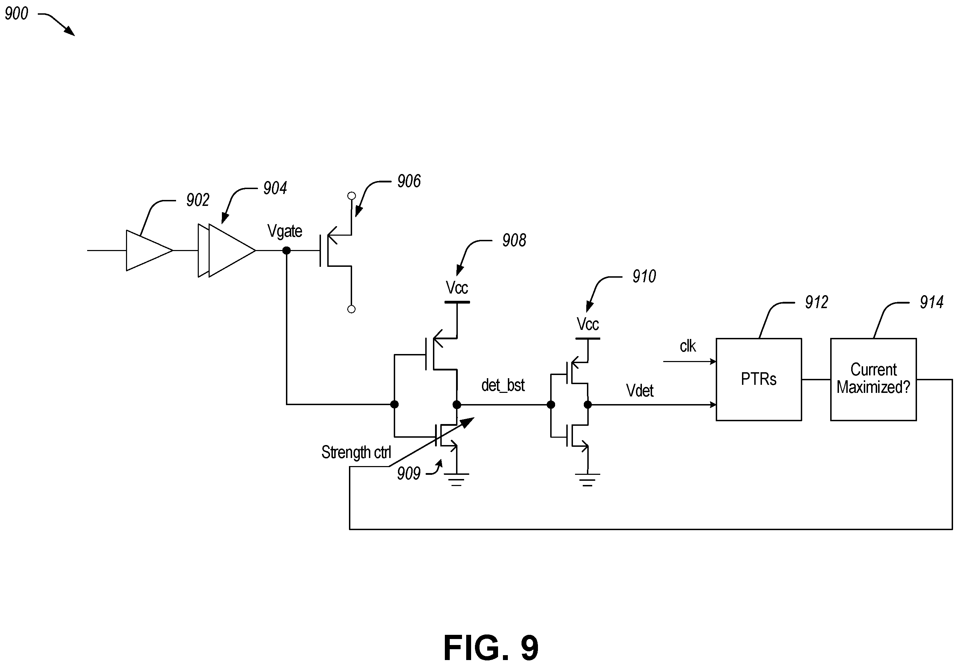

FIG. 9 is a block diagram of a self-detection circuit 900 using an adjustment loop to generate a self-detection deadtime clock signal, in accordance with some embodiments. Referring to FIG. 9, self-detection circuit 900 includes buffer circuit 902, driver circuits 904, PMOS transistor 906, a skewed inverter circuit 908, a skewed buffer circuit 910, PTRs 912, and current sensor 914. The skewed inverter circuit 908 can include an adjustable transistor 909. In some aspects, the NMOS driver strength (or PMOS) is regulated by a trim loop based on the maximum current readout from the current sensor 914.

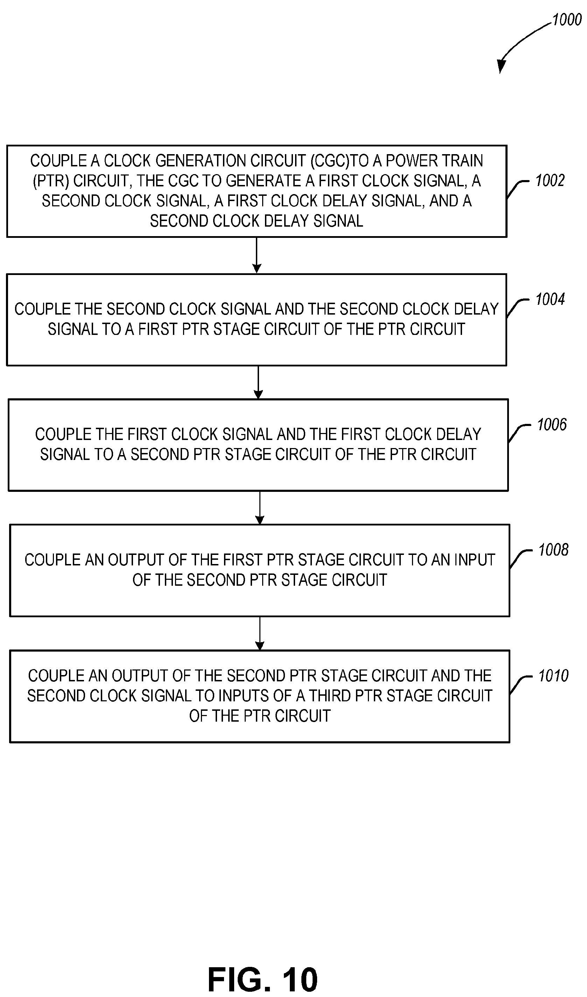

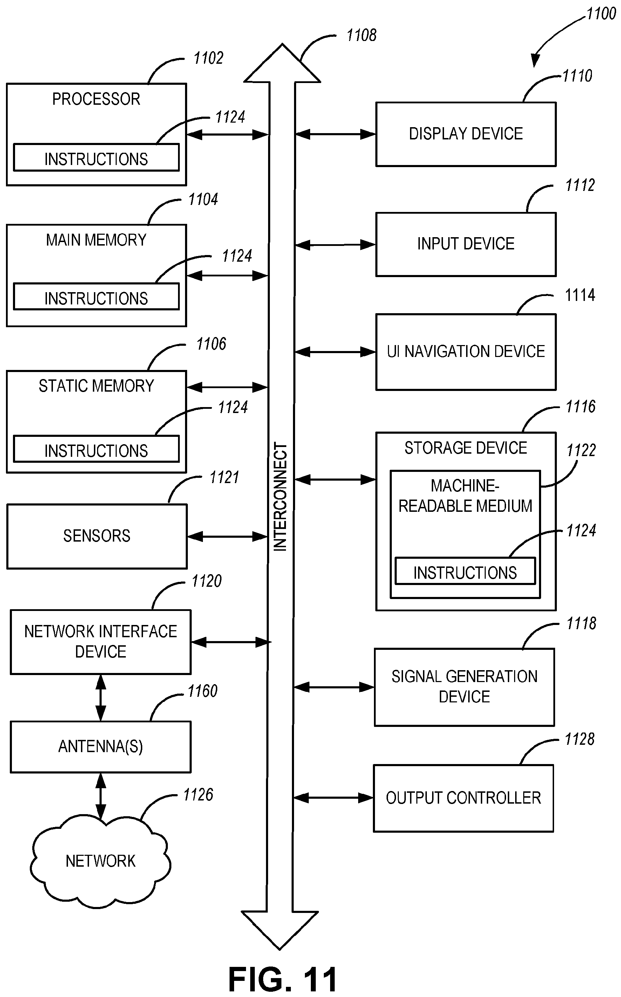

FIG. 10 is a flow diagram of an example method 1000 for manufacturing a converter circuit, in accordance with some embodiments. Referring to FIG. 10, method 1000 includes operations 1002, 1004, 1006, 1008, and 1010, which may be executed by a processor, an embedded controller, a receiver circuit, a transceiver circuit, or another processor of a computing device (e.g., hardware processor 1102 of machine 1100 illustrated in FIG. 11, which can include one or more of the circuits discussed in connection with FIGS. 1-9). In some embodiments, one or more of the circuits discussed in connection with FIGS. 1-9 can perform the functionalities (or include the configurations or circuitry) associated with FIG. 10, as well as one or more of the examples listed below.

At operation 1002, a clock generation circuit 104 is coupled to a power train (PTR) circuit 102. The clock generation circuit 104 is configured to generate a first clock signal, a second clock signal, a first clock delay signal, and a second clock delay signal (e.g., signals clk_stg2, clk, clk_stg2_dly, and clk_dly).

At operation 1004, the second clock signal (e.g., clk) and the second clock delay signal (e.g., clk_dly) are coupled to a first PTR stage circuit 114 of the PTR circuit 102.

At operation 1006, the first clock signal (e.g., clk_stg2) and the first clock delay signal (e.g., clk_stg2_dly) are coupled to a second PTR stage circuit 116 of the PTR circuit 102.

At operation 1008, an output of the first PTR stage circuit (e.g., st2_gnd) is coupled to an input of the second PTR stage circuit 116.

At operation 1010, an output of the second PTR stage circuit (e.g., St2out) and the second clock signal (e.g., clk) are coupled to inputs of a third PTR stage circuit 118 of the PTR circuit 102.

FIG. 11 illustrates a block diagram of an example machine 1100 upon which any one or more of the techniques (e.g., methodologies) discussed herein may perform. In alternative embodiments, the machine 1100 may operate as a standalone device or may be connected (e.g., networked) to other machines. In a networked deployment, machine 1100 may operate in the capacity of a server machine, a client machine, or both in server-client network environments. In an example, machine 1100 may function as a peer machine in a peer-to-peer (P2P) (or other distributed) network environment. The machine 1100 may be a personal computer (PC), a tablet PC, a set-top box (STB), a personal digital assistant (PDA), a portable communications device, a mobile telephone, a smartphone, a web appliance, a network router, switch or bridge, or any other computing device capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations. The terms "machine," "computing device," and "computer system" are used interchangeably.

Machine (e.g., computer system) 1100 may include a hardware processor 1102 (e.g., a central processing unit (CPU), a graphics processing unit (GPU), a hardware processor core, or any combination thereof), a main memory 1104, and a static memory 1106, some or all of which may communicate with each other via an interlink (e.g., bus) 1108. In some aspects, the main memory 1104, the static memory 1106, or any other type of memory (including cache memory) used by machine 1100 can be configured based on the disclosed techniques or can implement the disclosed memory devices.

Specific examples of main memory 1104 include Random Access Memory (RAM) and semiconductor memory devices, which may include, in some embodiments, storage locations in semiconductors such as registers. Specific examples of static memory 1106 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

Machine 1100 may further include a display device 1110, an input device 1112 (e.g., a keyboard), and a user interface (UI) navigation device 1114 (e.g., a mouse). In an example, the display device 1110, the input device 1112, and the UI navigation device 1114 may be a touchscreen display. The machine 1100 may additionally include a storage device (e.g., drive unit or another mass storage device) 1116, a signal generation device 1118 (e.g., a speaker), a network interface device 1120, and one or more sensors 1121, such as a global positioning system (GPS) sensor, compass, accelerometer, or other sensors. The machine 1100 may include an output controller 1128, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, the hardware processor 1102 and/or instructions 1124 may comprise processing circuitry and/or transceiver circuitry.

The storage device 1116 may include a machine-readable medium 1122 on which one or more sets of data structures or instructions 1124 (e.g., software) embodying or utilized by any one or more of the techniques or functions described herein can be stored. Instructions 1124 may also reside, completely or at least partially, within the main memory 1104, within static memory 1106, or the hardware processor 1102 during execution thereof by machine 1100. In an example, one or any combination of the hardware processor 1102, the main memory 1104, the static memory 1106, or the storage device 1116 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 1122 is illustrated as a single medium, the term "machine-readable medium" may include a single medium or multiple media (e.g., a centralized or distributed database and/or associated caches and servers) configured to store instructions 1124.

An apparatus of machine 1100 may be one or more of a hardware processor 1102 (e.g., a central processing unit (CPU), a graphics processing unit (GPU), a hardware processor core, or any combination thereof), a main memory 1104 and a static memory 1106, one or more sensors 1121, a network interface device 1120, one or more antennas 1160, a display device 1110, an input device 1112, a UI navigation device 1114, a storage device 1116, instructions 1124, a signal generation device 1118, and an output controller 1128. The apparatus may be configured to perform one or more of the methods and/or operations disclosed herein. The apparatus may be intended as a component of machine 1100 to perform one or more of the methods and/or operations disclosed herein and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 1100 and that causes machine 1100 to perform any one or more of the techniques of the present disclosure or that is capable of storing, encoding, or carrying data structures used by or associated with such instructions. Nonlimiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 1124 may further be transmitted or received over a communications network 1126 using a transmission medium via the network interface device 1120 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi^{®}, IEEE 802.16 family of standards known as WiMax^{®}), IEEE 802.8.4 family of standards, a Long Term Evolution (LTE) family of standards, a Universal Mobile Telecommunications System (UMTS) family of standards, peer-to-peer (P2P) networks, among others.

In an example, the network interface device 1120 may include one or more physical jacks (e.g., Ethernet, coaxial, or phone jacks) or one or more antennas to connect to the communications network 1126. In an example, the network interface device 1120 may include one or more antennas 1160 to wirelessly communicate using at least one single-input multiple-output (SIMO), multiple-input multiple-output (MIMO), or multiple-input single-output (MISO) techniques. In some examples, the network interface device 1120 may wirelessly communicate using multiple-user MIMO techniques. The term "transmission medium" shall be taken to include any intangible medium that can store, encode, or carry instructions for execution by machine 1100 and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a particular manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part, all, or any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at separate times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM), random access memory (RAM), magnetic disk storage media, optical storage media, flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, examples that include the elements shown or described are also contemplated. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc., are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments, such as part of a system on chip, a set of intercommunicating functional blocks, or similar, although the scope of the disclosure is not limited in this respect.

Described implementations of the subject matter can include one or more features, alone or in combination, as illustrated below by way of examples.

Example 1 is a converter circuit comprising: a first buffer circuit comprising an input terminal to receive a regulation clock signal and an output terminal to output a first clock signal; a second buffer circuit comprising an input terminal to receive the regulation clock signal; a first driver circuit comprising an input terminal coupled to an output terminal of the second buffer circuit; a first PMOS transistor comprising a gate terminal coupled to an output terminal of the first driver circuit; a first inverter circuit comprising an input terminal to receive the regulation clock signal; a second driver circuit comprising an input terminal coupled to an output terminal of the first inverter circuit; and a first NMOS transistor comprising a gate terminal coupled to an output terminal of the second driver circuit.

In Example 2, the subject matter of Example 1 includes, an AND gate comprising: a first input terminal coupled to the output terminal of the first driver circuit; a second input terminal coupled to the output terminal of the second driver circuit; and an output terminal to output a second clock signal.

In Example 3, the subject matter of Example 2 includes, a first power train (PTR) stage circuit comprising a first switched capacitor circuit, the first switched capacitor circuit coupled to a third clock signal, a fourth clock signal, and a voltage input signal, and the first switched capacitor circuit comprising an output terminal with a ground signal.

In Example 4, the subject matter of Example 3 includes, a fixed delay circuit comprising an input terminal coupled to the regulation clock signal and output terminals coupled to the third clock signal and the fourth clock signal.

In Example 5, the subject matter of Examples 3-4 includes, a second PTR stage circuit comprising gate logic coupled to a continuous capacitive voltage regulator (CCVR), the second PTR stage comprising: input terminals coupled to the voltage input signal, the first clock signal, the second clock signal, and the ground signal; and an output terminal coupled to a second voltage input signal.

In Example 6, the subject matter of Example 5 includes, wherein the CCVR comprises a set of PMOS transistors and a set of NMOS transistors, wherein the first PMOS transistor is a replica of one of the set of PMOS transistors, and wherein the first NMOS transistor is a replica of one of the set of NMOS transistors.

In Example 7, the subject matter of Examples 5-6 includes, a self-detection circuit comprising: a third buffer circuit comprising an input terminal coupled to the third clock signal; a third driver circuit comprising an input terminal coupled to an output terminal of the third buffer circuit; and a second PMOS transistor comprising a gate terminal coupled to an output terminal of the third driver circuit.

In Example 8, the subject matter of Example 7 includes, a skewed buffer circuit coupled to the gate of the second PMOS transistor; and a skewed inverter circuit coupled to the skewed buffer circuit, wherein an output terminal of the skewed inverter circuit comprises a fifth clock signal.

In Example 9, the subject matter of Example 8 includes, a third PTR stage circuit comprising a second switched capacitor circuit, the second switched capacitor circuit coupled to the third clock signal, the fifth clock signal, the second voltage input signal, and the second switched capacitor circuit comprising an output terminal with a voltage output signal.

In Example 10, the subject matter of Example 9 includes, a comparator circuit comprising: a first input terminal to receive the voltage output signal; a second input terminal to receive a reference clock signal from a digital-to-analog converter (DAC); and an output terminal coupled to the regulation clock signal.

In Example 11, the subject matter of Examples 2-10 includes, wherein the converter circuit comprises a system-on-chip (SoC), the SoC comprising an integrated circuit (IC), the IC comprising at least two of the first buffer circuit, the second buffer circuit, the first driver circuit, the first PMOS transistor, the first inverter circuit, the second driver circuit, the first NMOS transistor, and the AND gate.

In Example 12, the subject matter of Example 11 includes, wherein the SoC further comprises at least one connector, and wherein the at least one connector conforms with at least one of Universal Serial Bus (USB), High-Definition Multimedia Interface (HDMI), Thunderbolt, Peripheral Component Interconnect Express (PCIe), and Ethernet specifications.

Example 13 is an apparatus comprising: a clock generation circuit, the clock generation circuit comprising: an adaptive delay circuit to generate a first clock signal and a first clock delay signal based on a regulation clock signal; and a fixed time delay circuit to generate a second clock signal and a second clock delay signal based on the regulation clock signal; and a power train (PTR) circuit coupled to the clock generation circuit, the PTR circuit to: receive the first clock signal, the second clock signal, the first clock delay signal, and the second clock delay signal; and generate a voltage output signal based on the first clock signal, the second clock signal, the first clock delay signal, and the second clock delay signal.

In Example 14, the subject matter of Example 13 includes, wherein the PTR circuit further comprises: a first PTR stage circuit; and a second PTR stage circuit coupled to the first PTR stage circuit, the first PTR stage circuit to generate a ground signal based on the second clock signal and the second clock delay signal.

In Example 15, the subject matter of Example 14 includes, wherein the second PTR stage circuit is to generate a second voltage input signal based on a first voltage input signal, the first clock signal, the first clock delay signal, and the ground signal.

In Example 16, the subject matter of Example 15 includes, wherein the PTR circuit further comprises: a third PTR stage circuit comprising at least one PMOS transistor; and a self-detection circuit coupled to the third PTR stage circuit, the self-detection circuit is to generate a third clock delay signal based on the second clock signal, wherein the second clock signal is coupled to a gate of the at least one PMOS transistor.

In Example 17, the subject matter of Example 16 includes, wherein the self-detection circuit further comprises: a skewed buffer circuit coupled to the gate of the at least one PMOS transistor; and a skewed inverter circuit coupled to the skewed buffer circuit, the skewed inverter circuit to output the third clock delay signal.

In Example 18, the subject matter of Examples 16-17 includes, wherein the third PTR stage circuit is to generate a voltage output signal based on the second clock signal, the third clock delay signal, the and the second voltage input signal.

In Example 19, the subject matter of Example 18 includes, a comparator circuit to generate the regulation clock signal based on the voltage output signal.

Example 20 is a method for manufacturing a converter circuit, the method comprising: coupling a clock generation circuit to a power train (PTR) circuit; generating a first clock signal, a second clock signal, a first clock delay signal, and a second clock delay signal via the clock generation circuit; coupling the second clock signal and the second clock delay signal to a first PTR stage circuit of the PTR circuit; coupling the first clock signal and the first clock delay signal to a second PTR stage circuit of the PTR circuit; coupling an output of the first PTR stage circuit to an input of the second PTR stage circuit; and coupling an output of the second PTR stage circuit and the second clock signal to inputs of a third PTR stage circuit of the PTR circuit.

Example 21 is at least one machine-readable medium including instructions that, when executed by processing circuitry, cause the processing circuitry to perform operations to implement of any of Examples 1-20.

Example 22 is an apparatus comprising means to implement of any of Examples 1-20.

Example 23 is a system to implement of any of Examples 1-20.

Example 24 is a method to implement of any of Examples 1-20.

The above description is intended to be illustrative and not restrictive. For example, the above-described examples (or one or more aspects thereof) may be used in combination with others. Other embodiments may be used, such as by one of ordinary skill in the art upon reviewing the above description. The abstract is to allow the reader to ascertain the nature of the technical disclosure quickly. It is submitted with the understanding that it will not be used to interpret or limit the scope or meaning of the claims. Also, in the above Detailed Description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined regarding the appended claims, along with the full scope of equivalents to which such claims are entitled.

## Claims

1. A converter circuit comprising:
a first buffer circuit comprising an input terminal to receive a regulation clock signal and an output terminal to output a first clock signal;
a second buffer circuit comprising an input terminal to receive the regulation clock signal;
a first driver circuit comprising an input terminal coupled to an output terminal of the second buffer circuit;
a first PMOS transistor comprising a gate terminal coupled to an output terminal of the first driver circuit;
a first inverter circuit comprising an input terminal to receive the regulation clock signal;
a second driver circuit comprising an input terminal coupled to an output terminal of the first inverter circuit; and
a first NMOS transistor comprising a gate terminal coupled to an output terminal of the second driver circuit.

2. The converter circuit of claim 1, further comprising:
an AND gate comprising:
a first input terminal coupled to the output terminal of the first driver circuit;
a second input terminal coupled to the output terminal of the second driver circuit; and
an output terminal to output a second clock signal.

3. The converter circuit of claim 2, further comprising:
a first power train ,PTR, stage circuit comprising a first switched capacitor circuit, the first switched capacitor circuit coupled to a third clock signal, a fourth clock signal, and a voltage input signal, and the first switched capacitor circuit comprising an output terminal with a ground signal.

4. The converter circuit of claim 3, further comprising:
a fixed delay circuit comprising an input terminal coupled to the regulation clock signal and output terminals coupled to the third clock signal and the fourth clock signal.

5. The converter circuit of any of claims 3-4, further comprising:
a second PTR stage circuit comprising gate logic coupled to a continuous capacitive voltage regulator ,CCVR, the second PTR stage comprising:
input terminals coupled to the voltage input signal, the first clock signal, the second clock signal, and the ground signal; and
an output terminal coupled to a second voltage input signal.

6. The converter circuit of claim 5, wherein the CCVR comprises a set of PMOS transistors and a set of NMOS transistors, wherein the first PMOS transistor is a replica of one of the set of PMOS transistors, and wherein the first NMOS transistor is a replica of one of the set of NMOS transistors.

7. The converter circuit of any of claims 5-6, further comprising:
a self-detection circuit comprising:
a third buffer circuit comprising an input terminal coupled to the third clock signal;
a third driver circuit comprising an input terminal coupled to an output terminal of the third buffer circuit; and
a second PMOS transistor comprising a gate terminal coupled to an output terminal of the third driver circuit.

8. The converter circuit of claim 7, further comprising:
a skewed buffer circuit coupled to the gate of the second PMOS transistor;
a skewed inverter circuit coupled to the skewed buffer circuit, wherein an output terminal of the skewed inverter circuit comprises a fifth clock signal;
a third PTR stage circuit comprising a second switched capacitor circuit, the second switched capacitor circuit coupled to the third clock signal, the fifth clock signal, the second voltage input signal, and the second switched capacitor circuit comprising an output terminal with a voltage output signal; and
a comparator circuit comprising:
a first input terminal to receive the voltage output signal;
a second input terminal to receive a reference clock signal from a digital-to-analog converter ,DAC,; and
an output terminal coupled to the regulation clock signal.

9. The converter circuit of any of claims 2-8, wherein the converter circuit comprises a system-on-chip ,SoC, the SoC comprising an integrated circuit, IC, the IC comprising at least two of the first buffer circuit, the second buffer circuit, the first driver circuit, the first PMOS transistor, the first inverter circuit, the second driver circuit, the first NMOS transistor, and the AND gate.

10. The converter circuit of claim 9, wherein the SoC further comprises at least one connector, and wherein the at least one connector conforms with at least one of Universal Serial Bus ,USB, High-Definition Multimedia Interface ,HDMI, Thunderbolt, Peripheral Component Interconnect Express ,PCIe, and Ethernet specifications.

11. An apparatus comprising:
means for generating a first clock signal and a first clock delay signal based on a regulation clock signal;
means for generating a second clock signal and a second clock delay signal based on the regulation clock signal;
means for receiving the first clock signal, the second clock signal, the first clock delay signal, and the second clock delay signal; and
means for generating a voltage output signal based on the first clock signal, the second clock signal, the first clock delay signal, and the second clock delay signal.

12. The apparatus of claim 11, further comprising:
means for generating a ground signal based on the second clock signal and the second clock delay signal; and
means for generating a second voltage input signal based on a first voltage input signal, the first clock signal, the first clock delay signal, and the ground signal.

13. The apparatus of claim 12, further comprising:
means for generating a third clock delay signal based on the second clock signal;
means for generating a voltage output signal based on the second clock signal; and
means for generating the regulation clock signal based on the voltage output signal.

14. A method comprising:
coupling a clock generation circuit to a power train ,PTR, circuit, wherein the clock generation circuit is capable of generating a first clock signal, a second clock signal, a first clock delay signal, and a second clock delay signal;
coupling the second clock signal and the second clock delay signal to a first PTR stage circuit of the PTR circuit;
coupling the first clock signal and the first clock delay signal to a second PTR stage circuit of the PTR circuit;
coupling an output of the first PTR stage circuit to an input of the second PTR stage circuit; and
coupling an output of the second PTR stage circuit and the second clock signal to inputs of a third PTR stage circuit of the PTR circuit.

15. A computer program comprising instructions which, when the program is executed by a computer, cause the computer to carry out one or more operations according to at least one of Claims **11** to 14.
